# EUROPÄISCHE PATENTSCHRIFT

(11) **EP 2 550 734 B1**
(45) Veröffentlichungstag und Bekanntmachung des Hinweises auf die Patenterteilung: **08.05.2019**
(21) Anmeldenummer: 11710764.9
(22) Anmeldetag: 23.03.2011
(51) Int. Cl.: B62D 5/04, H02M 1/32, H02P 21/00, H02P 6/08, G01R 31/42, H02P 29/032

(54) **VERFAHREN ZUM BETRIEB EINES BÜRSTENLOSEN ELEKTROMOTORS**
METHOD FOR OPERATING A BRUSHLESS ELECTRIC MOTOR
PROCÉDÉ POUR FAIRE FONCTIONNER UN MOTEUR ÉLECTRIQUE SANS BALAIS

(30) Priorität: 23.03.2010 DE 102010003149
(43) Veröffentlichungstag der Anmeldung: 30.01.2013
(73) Patentinhaber: Continental Automotive GmbH, 30165 Hannover (DE)
(72) Erfinder: GUNSELMANN, Christian, 42113 Wuppertal (DE); FERNENGEL, Mathias, 63128 Dietzenbach (DE); BRUYANT, Nicolas, 31270 Cugnaux (DE); GUICHARD, Lionel, F-31100 Tuolouse (FR); PARETTE, Michel, F-31470 Fonsorbes (FR)
(86) Internationale Anmeldenummer: PCT/EP2011/054477
(87) Internationale Veröffentlichungsnummer: WO 2011/117311

(56) Entgegenhaltungen:
- EP-A1- 2 009 782
- DE-A1- 10 249 568
- DE-A1-102009 045 351
- DE-A1-102010 001 241
- US-B1- 6 653 812

## Beschreibung

Die vorliegende Erfindung betrifft ein Verfahren zum Betrieb eines bürstenlosen Elektromotors, dessen Wicklungen von einem Wechselrichter mit Hilfe von sechs Schalter angesteuert werden, wobei eine Erkennungseinheit zum Erkennen von defekten Schaltern, eine Einheit zur Spannungsmessung an den Ausgängen des Wechselrichters und ein Mikrocontroller zum Steuern der Schalter und zur Erzeugung einer pulsweitenmodulierten Spannungsversorgung der Wicklungen vorgesehen ist. Aus der DE 10 2010 000 852 A1 ist ein Verfahren bekannt, einen defekten Schalter zu lokalisieren und die Art des Defekts zu bestimmen. Mit dem vorbekannten Verfahren wird erkannt, ob der defekte Schalter leitend oder nicht-leitend defekt ist.

Aus der EP 2 009 782 A1 ist ein Verfahren zum Betrieb eines Elektromotors bekannt, bei dem, wenn ein Fehler erkannt wird, die Schalter der vom Fehler betroffenen Phase von der Ansteuerung ausgenommen werden.

Wechselrichter zur Ansteuerung bürstenloser Motoren bestehen in der Regel aus sechs Schaltern. Jeder Schalter kann nach einem Defekt prinzipiell zwei verschiedene Eigenschaften aufweisen: Nicht leitend, das heißt in der geöffneten Schalterstellung blockiert, oder leitend, das heißt in der geschlossenen Schalterstellung blockiert. Ein leitend defekter Schalter ist umgangssprachlich auch als Kurzschluss bekannt. Ein leitend defekter Schalter verursacht im Elektromotor ein Drehmoment entgegen der Betätigungsrichtung des Elektromotors. Besonders in sicherheitsrelevanten Anwendungen ist es dann wichtig, den Elektromotor in einem Notbetrieb weiter zu betreiben.

Es ist daher Aufgabe der vorliegenden Erfindung, ein Verfahren zum Betrieb eines bürstenlosen Elektromotors darzustellen, bei dem die Auswirkungen eines defekten Schalters zumindest teilweise ausgeglichen werden.

Diese Aufgabe wird durch ein Verfahren mit den kennzeichnenden Merkmalen des Patentanspruchs 1 gelöst. Dabei ist vorgesehen, dass nach Erkennung eines leitend defekten Schalters die Wicklungen derart angesteuert werden, dass ein im Mittel positives Motormoment erzeugt wird.

Dabei wird eine Ansteuerungsperiode des Elektromotors in mehrere Sektoren unterteilt, wobei in Abhängigkeit des defekten Schalters einzelne Sektoren zur Ansteuerung der Wicklungen deaktiviert werden, während die anderen Sektoren zur Ansteuerung der Wicklungen dienen. In einer konkretisierten Ausführung wird die Ansteuerungsperiode in zwölf Sektoren unterteilt, wobei jeder Sektor 30° entspricht.

Wobei die Ansteuerung der Wicklungen in denjenigen Sektoren erfolgt, in denen der leitend defekte Schalter auch im Normalbetrieb geschlossen ist.

Außerdem ist vorgesehen, dass die Wicklungen in den Sektoren, die der Ansteuerung dienen, mit Spannungswerten beaufschlagt werden, die den Auswirkungen des defekten Schalters entgegenwirken.

Die Schalter werden zu Schalterpaaren zusammengefasst und es ist vorgesehen, dass ein Schalterpaar nicht mehr angesteuert wird, wenn ein Schalter eines Schalterpaares leitend defekt ist.

Folgende Verfahrensschritte sind nach dem Verfahren vorgesehen: durch die folgende Verfahrensschritte:
- Erkennen eines defekten Schalters;
- Analysieren ob der defekte Schalter leitend oder nicht-leitend defekt ist und
- Sektorenweise Ansteuerung der Wicklungen.

Der Elektromotor wird nach einer vorab definierten Zeitspanne oder nach Vorliegen eines sicheren äußeren Zustands abgeschaltet.

Die Erfindung wird nachfolgend anhand eines Ausführungsbeispiels im Zusammenhang mit der beiliegenden Zeichnung näher erläutert. In der Zeichnung zeigen:
- Fig. 1: eine schematische Prinzipdarstellung der Wicklungen eines bürstenlosen Elektromotors und eines Wechselrichters an der das erfindungsgemäße Verfahren durchgeführt werden kann;
- Fig. 2: ein Diagramm mit Messwerten zur Verdeutlichung der Auswirkungen eines leitend defekten Schalters;
- Fig. 3: eine schematische Darstellung einer Ansteuerungsperiode des Elektromotors;
- Fig. 4: ein Fig. 2 entsprechendes Diagramm unter Berücksichtigung des vorliegenden Verfahrens;
- Fig. 5a,b: eine Darstellung eines Lenkradwinkels und eines Lenkmoments einer elektromechanischen Lenkung, bei dem das vorliegende Verfahren angewendet wird und
- Fig. 6a,b: eine Fig. 5a, b entsprechende Darstellung bei einem anderen Lenkmanöver.

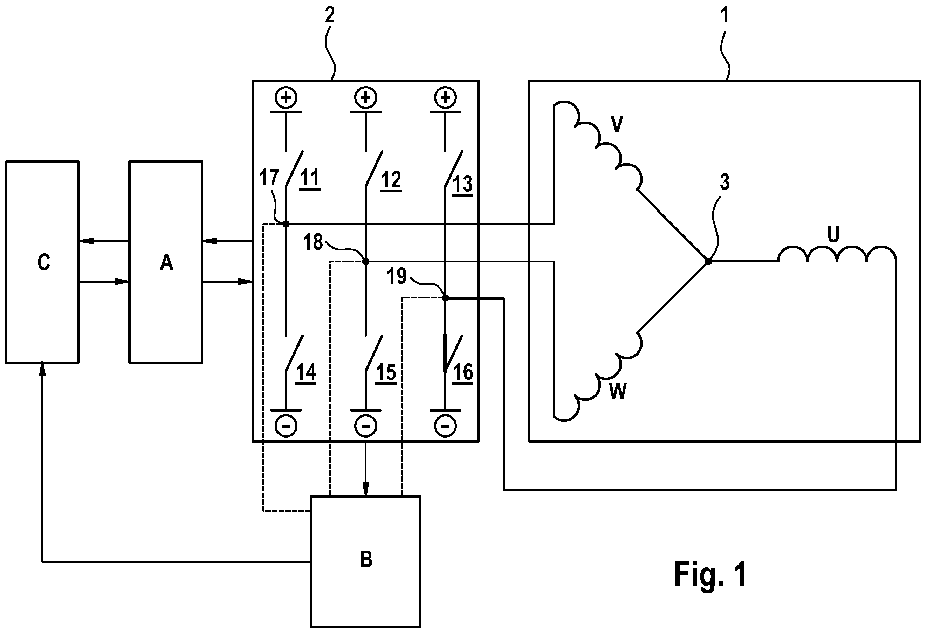

In Fig. 1 ist schematisch ein bürstenloser Elektromotor 1 einer elektromechanischen Lenkvorrichtung dargestellt, dessen Wicklungen U, V, W von einem Wechselrichter 2 angesteuert werden. Zu diesem Zweck weist der Wechselrichter 2 sechs Schalter 11, 12, 13, 14, 15, 16 auf, wobei die in Fig. 1 oberen Schalter 11, 12, 13 der positiven Versorgungsspannung und die in Fig. 1 unteren Schalter 14, 15, 16 der negativen Versorgungsspannung zugeordnet sind. So versorgen beispielsweise die Schalter 11 und 14 die Wicklung V mit einer geeigneten Versorgungsspannung. Die Wicklungen U, V, W werden mit pulsweitenmodulierten Spannungswerten PWM_{U}, PWM_{V}, PWM_{W} angesteuert, die ein Mikrocontroller C vorgibt. Wie Fig. 1 weiter entnehmbar ist, befinden sich zwischen den Schaltern 11, 12, 13, die der positiven Versorgungsspannung zugeordnet sind, und den Schaltern 14, 15, 16, die der negativen Versorgungsspannung zugeordnet sind, Abgreifpunkte 17, 18, 19, an denen die an den Wicklungen U, V, W anliegende Spannung abgegriffen wird und einer Einheit B zur Spannungsmessung zugeführt wird. Die Messergebnisse der Einheit B zur Spannungsmessung werden dem Mikrocontroller C zugeführt, der einerseits die Schalter 11, 12, 13, 14, 15, 16 steuert und andererseits die von der Spannungsmessungseinheit B erzeugten Informationen auswertet. Außerdem ist eine Erkennungseinheit A zum Erkennen von defekten Schaltern 11, 12, 13, 14, 15, 16 vorgesehen. Die von der Erkennungseinheit A erzeugten Informationen werden ebenfalls dem Mikrocontroller C zur Auswertung zugeführt.

In einer Ausführungsform in der Praxis werden die Schalter 11, 12, 13, 14, 15, 16 durch Halbleiterschalter bzw. Transistoren oder MOSFETs gebildet. Die Erkennungseinheit A ist in der Praxis als Brückentreiber ausgebildet und legt an die als Transistoren ausgebildeten Schalter 11, 12, 13, 14, 15, 16 eine Spannung an und kontrolliert, ob die Schalterstellung des Transistors wechselt. Die Einheit B zur Spannungsmessung an den Abgreifpunkten 17, 18, 19 ist in der Praxis als Spannungsteiler ausgebildet und ermittelt das Tastverhältnis einer pulsweitenmodulierten Spannung. Das Tastverhältnis entspricht dabei dem Quotienten aus Impulsdauer und Periodendauer.

Jeder Schalter 11, 12, 13, 14, 15, 16 kann prinzipiell zwei verschiedene Arten eines Defekts aufweisen bzw. befindet sich nach einem Defekt grundsätzlich in einer der beiden nachfolgend beschrieben Zustände: Nicht leitend defekt, das heißt in der geöffneten Schalterstellung blockiert, oder leitend defekt, das heißt in der geschlossenen Schalterstellung blockiert. Ein leitend defekter Schalter 11, 12, 13, 14, 15, 16 ist umgangssprachlich auch als Kurzschluss bekannt. Da ein leitend defekter Schalter 11, 12, 13, 14, 15, 16 für den Betrieb der elektromechanischen Lenkvorrichtung wesentlich kritischer ist, wird im Folgenden von diesem Fehlerfall ausgegangen. In vorliegenden Ausführungsbeispiel nach Fig. 1 ist der Schalter 16, der der Windung U zugeordnet ist, als leitend defekt dargestellt.

Besonders in sicherheitsrelevanten Anwendungen, wie in einer elektromechanischen Lenkvorrichtung, ist es wichtig, sehr schnell zu reagieren, um den Elektromotor 1 in einen Notbetrieb zu überführen. Der Fehlerfall des leitend defekten Schalters führt zu einem erhöhten Lenkmoment, da der Fahrzeugführer im Fehlerfall den Elektromotor 1 im Generatorbetrieb bewegt und dabei einen Strom induziert, der der Lenkbewegung am Lenkrad gerade entgegen wirkt. Dieses entgegen der Drehrichtung des Fahrzeugführer wirkende Moment wird im Folgenden Bremsmoment genannt. Durch den Kurzschluss im Wechselrichter 2 wird in einer permanent erregten Synchronmaschine ein drehzahlabhängiges Bremsmoment erzeugt. Durch den defekt leitenden Schalter 16 und die Body-Dioden der Schalter 14, 15 entsteht durch Induktion ein Stromschluss über die Motorwicklungen U, V, W.

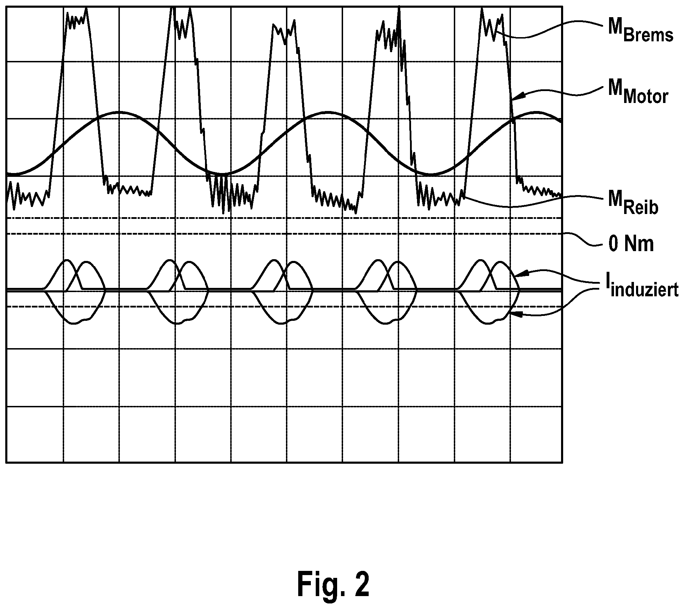

In Fig. 2 ist ein Diagramm mit Messwerten dargestellt, das an einem Elektromotor 1 mit einem leitend defekten Schalter 16 aufgenommen wurde. Die sinusförmige Kurve steht für die verschiedenen Motorphasen des sich drehenden Elektromotors 1. Eine Ansteuerungsperiode beträgt 2Π bzw. 360°. Im unteren Bereich des in Fig. 2 dargestellten Diagramms sind die induzierten Ströme I_{induziert} der drei Motorwicklungen U, V, W dargestellt. Die obere Hälfte zeigt das Drehmoment M_{Motor} des Elektromotors 1. Die induzierten Ströme I_{induziert} sorgen dafür, dass das Motormoment M_{Motor} in einem Winkelbereich von ca. 180° eine Größe M_{Brems} erreicht. Gleichzeitig ist erkennbar, dass das Motormoment M_{Motor} in den Winkelbereichen, in denen keine Ströme induziert werden, nicht auf 0 Nm abfällt, sondern ein Restniveau M_{Reib} behält. Der induzierte Strom I_{induziert} fließt nur in einem eingeschränkten Winkelbereich von etwa 180°. Im restlichen Winkelbereich ist der Elektromotor 1 stromlos und es wirkt kein störendes Bremsmoment.

Selbst wenn man die Ansteuerung des Elektromotors 1 stoppen würde, wäre das Problem bei einer elektromechanischen Lenkeinrichtung nicht gelöst: Durch das Drehen des Lenkrades würde der Fahrzeugführer ständig neue Ströme I_{induziert} induzieren, die seiner Drehbewegung am Lenkrad entgegen wirken. Ein Abschalten der Ansteuerung des Elektromotors 1 ist daher nicht zielführend. Allerdings kann das Fortführen der Ansteuerung des Elektromotors 1 im Normalbetrieb bei diesem Fehler extrem hohe Motorströme erzeugen die zu weiteren Zerstörungen im System führen können. Eine fortwährende Ansteuerung im Normalbetrieb trotz des leitend defekten Schalters 16 muss daher zwingend vermieden werden.

Aus dem Stand der Technik ist die Lösung bekannt, im Fall eines leitend defekten Schalters 16 einen Sicherheitsschalter zu öffnen, um den Kurzschluss durch einen im leitenden Zustand blockierten Schalter 16 aufzuheben. Ein derartiger Sicherheitsschalter wird beispielsweise im Sternpunkt 3 der Wicklungen U, V, W angeordnet und ist auch als Sternpunktrelais bekannt. Durch das Öffnen eines Sicherheitsschalters wird der erhöhte Lenkaufwand für den Fahrzeugführer verringert. Allerdings erhält der Fahrzeugführer dann auch keine Lenkunterstützung durch den Elektromotor 1 mehr.

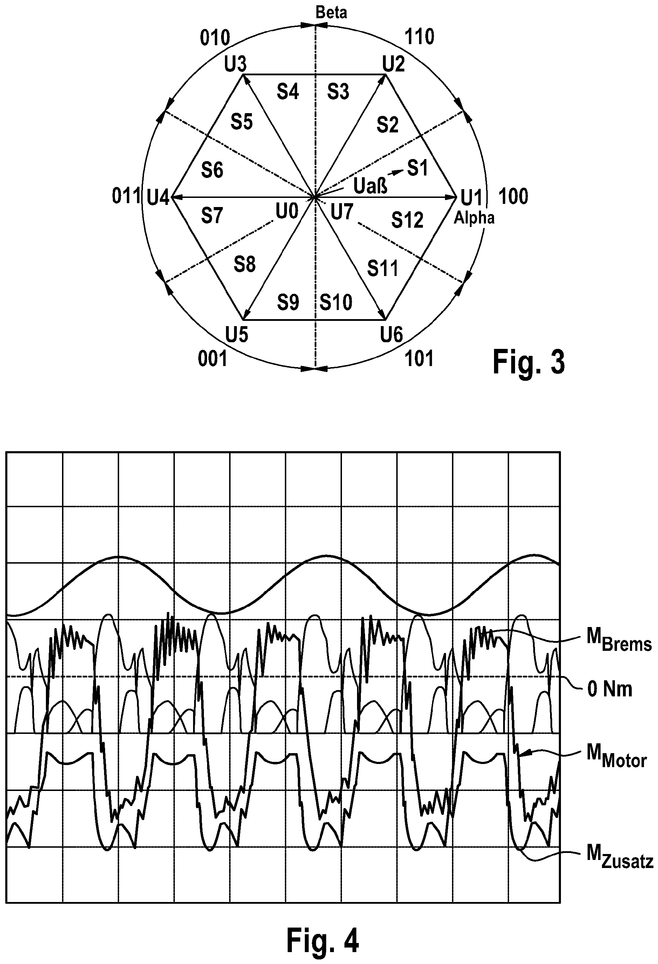

Das hier beschriebene Verfahren sieht dagegen vor, auf die Öffnung des Sternpunkts 3 zu verzichten und den Elektromotor 1 in einem Notbetrieb weiter zu betreiben. Dazu ist vorgesehen, dass nach Erkennung eines leitend defekten Schalters 16 die Wicklungen U, V, W derart angesteuert werden, dass ein im Mittel positives Motormoment erzeugt wird. Dazu wird, wie in Fig. 3 dargestellt, eine Ansteuerungsperiode des Elektromotors 1 in zwölf Sektoren S1 bis S12 von jeweils 30° unterteilt. In Abhängigkeit davon, welcher der Schalter 11, 12, 13, 14, 15, 16 leitend defekt ist, werden einzelne Sektoren deaktiviert, während die anderen Sektoren zur Ansteuerung der Wicklungen U, V, W verwendet werden. Im hier beschriebenen Fall ist der untere Schalter 16 der Wicklung U leitend defekt und es werden vier Sektoren S1, S2, S11, S12 zur Ansteuerung der Wicklungen U, V, W deaktiviert, während die anderen acht Sektoren S3 bis S10 zur Ansteuerung der Wicklungen U, V, W dienen. Die passiven Sektoren S1, S2, S11, S12 werden zur Ansteuerung nicht verwendet, da eine Ansteuerung der Wicklungen U, V, W in diesen Sektoren die Bremswirkung des gegen die beabsichtige Wirkrichtung des Elektromotors 1 wirkende Bremsmoments noch verstärken würde. Grundsätzlich sind diejenigen Sektoren aktiv, in denen der defekte Schalter auch im Normalbetrieb des Elektromotors 1 leitend, d.h. geschlossen, wäre. Im hier beschriebenen Ausführungsbeispiel sind das die Sektoren S3 bis S10 der linken Halbebene. Dies ist erkennbar an der führenden Null in der Kennzeichnung 010, 011 und 001, wobei die erste Ziffer für Wicklung U steht und eine Null bedeutet, dass der untere Schalter 16 im leitenden Zustand, also geschlossen ist. Außerdem werden jeweils die beiden direkt angrenzenden Sektoren S10 und S3 zur Ansteuerung der Wicklungen verwendet.

Die beiden Schalter 13, 16 des Schalterpaares mit einem Defekt werden grundsätzlich nicht mehr angesteuert. Die übrigen vier Schalter 11, 12, 14, 15 der Schalterpaare 11, 14; 12, 15 werden in den acht aktiven Sektoren S3 bis S10 nach einem vorab bestimmten Schema angesteuert. Das Ansteuerschema ist abhängig von der Drehrichtung des Elektromotors 1. Das Ansteuerschema kann dabei in Abhängigkeit vom Betriebszustand des Systems, wie beispielsweise Fahrzeuggeschwindigkeit, Lenkradeinschlag, Drehzahl des Fahrzeugantriebsmotors und der Bordnetzspannung verändert werden. Innerhalb eines aktiven Sektors S3 bis S10 werden definierte Spannungswerte über die Schalter des Wechselrichters 2 an die Windungen V und W angelegt.

In Fig. 4 ist die Wirkung dieser sektorenweisen Ansteuerung der Wicklungen U, V, W dargestellt. Die sinusförmige Kurve zeigt wiederum die Motordrehung. Das negative Motormoment M_{Brems} wird von dem zusätzlichen, unterstützenden Motormoment M_{Zusatz}, das durch die Ansteuerung in den aktiven Sektoren S3 bis S10 erzielt wird, soweit kompensiert, dass das Motormoment M_{Motor} insgesamt positiv ist. Zur Erläuterung wird festgestellt, dass in dem in Fig. 4 dargestellten Diagramm das positive mittlere Motormoment M_{Motor} dabei durch negative Werte dargestellt ist. Sobald das Kraftfahrzeug in einen sicheren Zustand überführt ist, wird der Elektromotor 1 deaktiviert.

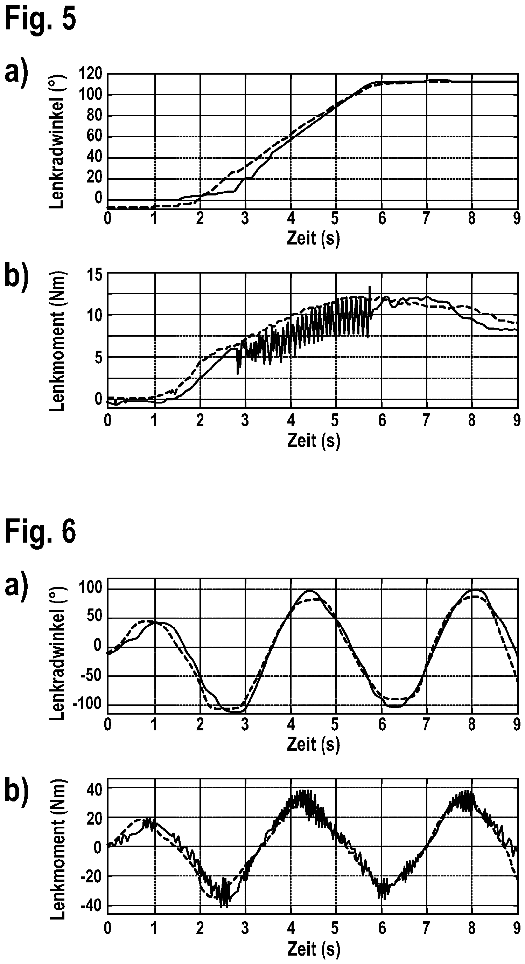

Anhand der Fig. 5a, b und Fig. 6a, b wird das beschriebene Verfahren mit der aus dem Stand der Technik vorbekannten Lösung, der Öffnung des Sternpunkts 3 verglichen. Die Fig. 5a und 6a zweigen jeweils den Lenkradwinkel, den der Fahrzeugführer am Lenkrad einschlägt, während die Fig. 5b und 6b das Lenkmoment darstellen. Auf der Abszisse ist bei allen Figuren die Zeit dargestellt. Die gestrichelte Linie stellt den Lenkradwinkel bzw. das Lenkmoment bei geöffnetem Sternpunkt 3 dar, während die durchgezogene Linie dieselben Größen nach dem oben beschriebenen Verfahren darstellen. Als Fehler wird wiederum der untere Schalter 16 der Wicklung U als leitend defekt angenommen.

Das in Fig. 5a, b dargestellte Lenkmanöver entspricht dem Einlenken auf eine Kreisbahn bei einer Fahrzeuggeschwindigkeit von 10 km/h und einem Radius von 20m. Der Fig. 5a ist dabei entnehmbar, dass der Fahrzeugführer in beiden Fällen in etwa gleichschnell auf die Kreisbahn einlenkt. In Fig. 5b ist das Lenkmoment, das der Fahrzeugführer am Lenkrad spürt dargestellt. Die gestrichelte Linie ist dabei das Lenkmoment bei geöffnetem Sternpunkt 3. Deutlich ist erkennbar, dass das Lenkmoment, das mit der durchgezogenen Linie dargestellt ist und das nach dem hier beschriebenen Verfahren realisiert wird, eine deutliche Unterstützung durch den Elektromotor 1 erfährt. Trotz des inneren Bremsmoments wird durch die beschriebene Regelung ein positives Motormoment erzielt.

Die Fig. 6a und b zeigen den Lenkradwinkel bzw. das Lenkmoment bei einer Slalomfahrt des Kraftfahrzeugs. Wie Fig. 6a entnehmbar ist, dreht der Fahrzeugführer bei dieser Slalomfahrt das Lenkrad jeweils um etwa 100° nach links und um etwa 100° nach rechts. Das Lenkmoment bei geöffnetem Sternpunkt, das in Fig. 6b mit der gestrichelten Linie ist gleichmäßiger als das Lenkmoment, das der Fahrzeugführer bei dem hier beschriebenen Verfahren spürt. Vom Betrag sind beide Lenkmomente in etwa gleich. Nach einer vorab definierten Zeitspanne oder nach Vorliegen eines sicheren äußeren Zustands wird der Elektromotor 1 abgeschaltet.

Wie es aus den Fig. 5a, b und 6a, b ersichtlich geworden ist, kann auf ein Relais am Sternpunkt 3 verzichtet werden und der Fehler eines leitend defekten Schalter kann durch eine reine Ansteuerungsmaßnahme ausgeglichen werden. Das bedeutet, dass auf elektronische Bauteile, wie das Sternpunktrelais verzichtet werden kann.

## Patentansprüche

1. Verfahren zum Betrieb eines bürstenlosen Elektromotors (1), dessen Wicklungen (U, V, W) von einem Wechselrichter (2) mit Hilfe von sechs Schalter (11, 12, 13, 14, 15, 16) angesteuert werden, wobei eine Erkennungseinheit (A) zum Erkennen von defekten Schaltern (11, 12, 13, 14, 15, 16), eine Einheit (B) zur Spannungsmessung an den Ausgängen (17, 18, 19) des Wechselrichters (2) und ein Mikrocontroller (C) zum Steuern der Schalter (11, 12, 13, 14, 15, 16) und zur Erzeugung einer pulsweitenmodulierten Spannungsversorgung (PWM_{U}, PWM_{V}, PWM_{W}) der Wicklungen (U, V, W) vorgesehen ist, wobei nach Erkennung eines leitend defekten Schalters (11, 12, 13, 14, 15, 16) die Wicklungen (U, V, W) nach einem vorab definierten Schema der pulsweitenmodulierten Spannungsversorgung derart angesteuert werden, dass mit den nicht defekten Schaltern (11, 12, 14, 15) ein unterstützendes Motormoment (M_{Zusatz}) erzeugt wird, das einem negativen Motormoment (M_{Brems}) entgegenwirkt, so dass ein im Mittel positives Motormoment erzeugt wird, **dadurch gekennzeichnet, dass** eine Ansteuerungsperiode des Elektromotors (1) mittels Raumzeigermodulation in mehrere Sektoren (S1 bis S12) unterteilt wird, wobei in Abhängigkeit des defekten Schalters einzelne Sektoren (S1, S2, S11, S12) zur Ansteuerung der Wicklungen (U, V, W) deaktiviert werden, während die anderen Sektoren (S3 bis S10) zur Ansteuerung der Wicklungen (V, W) dienen, wobei die Ansteuerung der Wicklungen (V, W) in denjenigen Sektoren (S3 bis S10) erfolgt, in denen der leitend defekte Schalter (16) auch im Normalbetrieb geschlossen ist.

2. Verfahren nach Anspruch 1, **dadurch gekennzeichnet, dass** die Ansteuerungsperiode in zwölf Sektoren (S1 bis S12) unterteilt wird, wobei jeder Sektor (S1 bis S12) 30° entspricht.

3. Verfahren nach einem der Ansprüche 1 bis 2, **dadurch gekennzeichnet, dass** die Wicklungen (V, W) in den Sektoren (S3 bis S10), die der Ansteuerung dienen, mit Spannungswerten (PWM_{V}, PWM_{W}) beaufschlagt werden, die den Auswirkungen des defekten Schalters (16) entgegenwirken.

4. Verfahren nach einem der Ansprüche 1 bis 2, **dadurch gekennzeichnet, dass** die Schalter (11, 12, 13, 14, 15, 16) zu Schalterpaaren (11, 14; 12, 15; 13, 16) zusammengefasst werden und dass ein Schalterpaar (11, 14; 12, 15; 13, 16) nicht mehr angesteuert wird, wenn ein Schalter (11, 12, 13, 14, 15, 16) eines Schalterpaares (11, 14; 12, 15; 13, 16) leitend defekt ist.

5. Verfahren nach einem der vorhergehenden Ansprüche 1 bis 4 **gekennzeichnet durch** die folgende Verfahrensschritte:
• Erkennen eines defekten Schalters (11, 12, 13, 14, 15, 16);
• Analysieren ob der defekte Schalter (16) leitend oder nicht-leitend defekt ist und
• Sektorenweise Ansteuerung der Wicklungen (U, V, W).

6. Verfahren nach Anspruch 5 **dadurch gekennzeichnet, dass** der Elektromotor (1) nach einer vorab definierten Zeitspanne oder nach Vorliegen eines sicheren äußeren Zustands abgeschaltet wird.

## Claims

1. Method for operating a brushless electric motor (1), the windings (U, V, W) of which are actuated by an inverter (2) by means of six switches (11, 12, 13, 14, 15, 16), wherein an identification unit (A) is provided for identifying defective switches (11, 12, 13, 14, 15, 16), a unit (B) is provided for voltage measurement at the outputs (17, 18, 19) of the inverter (2) and a microcontroller (C) is provided for controlling the switches (11, 12, 13, 14, 15, 16) and for generating a pulse-width-modulated power supply (PWM_{U}, PWM_{V}, PWM_{W}) for the windings (U, V, W), wherein, after a defectively switched-on switch (11, 12, 13, 14, 15, 16) is identified, the windings (U, V, W) are actuated according to a previously defined scheme of the pulse-width-modulated power supply in such a way that, by means of the non-defective switches (11, 12, 14, 15), a supporting motor moment(Madd) that counteracts a negative a motor moment (M_{brake}) is generated so that a motor moment which is positive on average is generated **characterized in that** an actuation period of the electric motor (1) is subdivided into a plurality of sectors (S1 to S12) by means of space vector modulation, wherein, depending on the defective switch, individual sectors (S1, S2, S11, S12) for actuating the windings (U, V, W) are deactivated, while the other sectors (S3 to S10) are used to actuate the windings (V, W), wherein the windings (V, W) are actuated in those sectors (S3 to S10) in which the defectively switched-on switch (16) is also closed in the normal mode.

2. Method according to Claim 1, **characterized in that** the actuation period is subdivided into twelve sectors (S1 to S12), wherein each sector (S1 to S12) corresponds to 30°.

3. Method according to one of Claims 1 to 2, **characterized in that** voltage values (PWM_{V}, PWM_{W}), which counteract the effects of the defective switch (16), are applied to the windings (V, W) in the sectors (S3 to S10), which are used for the actuation.

4. Method according to one of Claims 1 to 2, **characterized in that** the switches (11, 12, 13, 14, 15, 16) are combined into switch pairs (11, 14; 12, 15; 13, 16), and **in that** a switch pair (11, 14; 12, 15; 13, 16) is no longer actuated when a switch (11, 12, 13, 14, 15, 16) of a switch pair (11, 14; 12, 15; 13, 16) is defectively switched on.

5. Method according to one of the preceding Claims 1 to 4, **characterized by** the following method steps:
• identifying a defective switch (11, 12, 13, 14, 15, 16);
• analyzing whether the defective switch (16) is defectively switched on or switched off; and
• actuating the windings (U, V, W) sector-by-sector.

6. Method according to Claim 5, **characterized in that** the electric motor (1) is switched off after a previously defined time period or once a safe external state is present.

## Revendications

1. Procédé pour faire fonctionner un moteur électrique sans balais (1), dont les enroulements (U, V, W) sont commandés par un onduleur (2) à l'aide de six commutateurs (11, 12, 13, 14, 15, 16), dans lequel il est prévu une unité de détection (A) servant à détecter des commutateurs défectueux (11, 12, 13, 14, 15, 16), une unité (B) servant à mesurer la tension aux sorties (17, 18, 19) de l'onduleur (2) et un microcontrôleur (C) servant à commander les commutateurs (11, 12, 13, 14, 15, 16) et à générer une alimentation en tension modulée par impulsions en largeur (PWM_{U}, PWM_{V}, PWM_{W}) des enroulements (U, V, W), dans lequel, après détection d'un commutateur (11, 12, 13, 14, 15, 16) présentant un défaut de conduction, les enroulements (U, V, W) sont commandés conformément à un schéma prédéterminé de l'alimentation électrique modulée par impulsions en largeur de manière à générer un couple moteur auxiliaire (Mₐᵤₓᵢₗᵢₐᵢᵣₑ) au moyen des commutateurs (11, 12, 14, 15) non défectueux, qui contrecarre un couple moteur négatif (M_{freinage}), de manière à générer un couple moteur moyen positif, **caractérisé en ce qu'**une période de commande du moteur électrique (1) est divisée en une pluralité de secteurs (S1 à S12) au moyen d'une modulation vectorielle spatiale, dans lequel des secteurs individuels (S1, S2, S11, S12) sont désactivés en fonction du commutateur défectueux pour commander les enroulements (U, V, W), alors que les autres secteurs (S3 à S10) servent à commander les enroulements (V, W), dans lequel la commande des enroulements (V, W) est effectuée dans les secteurs (S3 à S10) dans lesquels le commutateur (16) présentant un défaut de conduction est également fermé en fonctionnement normal.

2. Procédé selon la revendication 1, **caractérisé en ce que** la période de commande est divisée en douze secteurs (S1 à S12), dans lequel chaque secteur (S1 à S12) correspond à 30°.

3. Procédé selon l'une des revendications 1 à 2, **caractérisé en ce que** les enroulements (V, W) se trouvant dans les secteurs (S3 à S10) servant à la commande sont attaqués avec des valeurs de tension (PWM_{V}, PWM_{W}) qui compensent les effets du commutateur défectueux (16).

4. Procédé selon l'une des revendications 1 à 2, **caractérisé en ce que** les commutateurs (11, 12, 13, 14, 15, 16) sont combinés en paires de commutateurs (11, 14 ; 12, 15 ; 13, 16) et **en ce qu'**une paire de commutateurs (11, 14 ; 12, 15 ; 13, 16) n'est plus commandée si un commutateur (11, 12, 13, 14, 15, 16) d'une paire de commutateurs (11, 14 ; 12, 15 ; 13, 16) présente un défaut de conduction.

5. Procédé selon l'une des revendications 1 à 4 précédentes, **caractérisé par** les étapes de procédé suivantes :
- détecter un commutateur défectueux (11, 12, 13, 14, 15, 16) ;
- analyser si le commutateur défectueux (16) présente un défaut de conduction ou de non-conduction ; et
- commander de manière sectorielle les enroulements (U, V, W).

6. Procédé selon la revendication 5, **caractérisé en ce que** le moteur électrique (1) est arrêté après une période de temps prédéfinie ou après la présence d'un état externe sûr.
